# EUROPEAN PATENT SPECIFICATION

(11) **EP 2 901 212 B1**
(45) Date of publication and mention of the grant of the patent: **25.05.2022**
(21) Application number: 13840656.6
(22) Date of filing: 27.09.2013
(51) Int. Cl.: G03F 1/38, H01L 21/033, H01L 21/308

(54) **METHOD FOR FABRICATION OF NANO-STRUCTURES**
VERFAHREN ZUR HERSTELLUNG VON NANOSTRUKTUREN
PROCÉDÉ DE FABRICATION DE NANOSTRUCTURES

(30) Priority: 28.09.2012 US 201213631593
(43) Date of publication of application: 05.08.2015
(73) Proprietor: Nanotech Security Corp., British Columbia, V5A 4RA (CA)
(72) Inventor: CHUO, Yindar, Burnaby, British Columbia V5C 0A3 (CA); LANDROCK, Clinton K., North Vancouver, British Columbia V7P 1W8 (CA); OMRANE, Badr, Burnaby, British Columbia V5A 1M5 (CA); KAMINSKA, Bozena, Vancouver, British Columbia V5Y 1R8 (CA)
(74) Representative: Cobbold, Alistair John
(86) International application number: PCT/CA2013/050740
(87) International publication number: WO 2014/047740

(56) References cited:
- WO-A1-2011/139593
- WO-A2-2005/094231
- JP-A- S5 691 434
- US-A- 4 497 684
- US-A- 5 130 764
- US-A- 5 130 764
- US-A1- 2009 315 153
- US-A1- 2010 117 188

## Description

### FIELD OF THE INVENTION

The present invention relates generally to methods of fabrication of nano-structures. More particularly, the present invention relates to methods of rapid fabrication of original nano-structures on substrate surfaces.

### BACKGROUND TO THE INVENTION

The development and advancement of many applications of nano-technology such as those involving the use of nano-structures (structural features having dimensions in the range of nanometers) requires the ability to precisely and repeatably produce arrays of nano-structures in the surfaces of a range of materials. One approach for production of surface nano-structures in a repeatable manner involves the use of a master stamp or die comprising original nano-structures on its surface, in order to stamp, imprint, emboss or otherwise impress the nano-structures into the surface of imprintable materials in which surface nano-structures are desired, or to use as master stamps or templates for photolithographic or shadow masking nano-structure reproduction techniques, for example.

However, the ability to use such desirably repeatable imprinting, stamping, embossing or photolithographical reproduction techniques requires the production of highly precise original nano-structures in a preferably durable substrate material that is suitable for use as a master, die or template in a reproduction process. Such production of master original nano-structures in the surface of durable substrates suitable for use as master stamps or shims may require the individual registration of very large numbers of precisely formed and spaced nano-structures over relatively large surface areas (such as typically at least several square centimeters or more) in order to create nano-structure master or stamp blocks which can effectively used for reproduction of nano-structures in desired materials. Such registration or patterning of relatively large surface areas of original nano-structures on master substrate materials by conventionally known patterning methods such as ablation (such as by focused ion beam milling), radiation lithography (such as electron beam lithography) or laser interference lithography patterning methods may require undesirably long and correspondingly expensive use of patterning tools, due to the size and number of original nano-structures which must be individually patterned in their entirety in order to produce a given surface area of a desired nano-structure pattern on a master, stamp or template substrate.

Accordingly, there is a need for additional and improved methods of fabrication of original nano-structures in substrate surfaces which may desirably reduce the necessary time and/or expense of patterning tool use for the production of nano-structure masters or templates.

The document US 4 497 684 discloses a process wherein a substrate is covered with a first and a second sacrificial layer, and is covered in turn with a photoresist layer. A pattern is written in the photoresist layer and is extended through the sacrificial layers to provide an overhanging lip portion of 1000 Angströms.

### SUMMARY OF THE INVENTION

According to one embodiment of the present invention, a method of fabricating nano-structures on a substrate surface is provided as set out in the appended claims.

According to the present invention, a method of fabricating nano-structures on a planar substrate surface by reducing the use of a writing tool is provided. The method of fabrication comprises the steps of:
a) providing a suitable substrate material comprising a substrate, and process layers sequentially deposited on said substrate comprising: a lift-off layer in contact with said substrate, a pattern transfer layer on top of said lift-off layer, and a writing layer on top of said pattern transfer layer, wherein said writing layer comprises a photoresist or electron-beam resist material;
b) patterning pilot nano-structures in said writing layer by exposure of said writing layer to an electron-beam lithography tool to reveal said pattern transfer layer underneath at locations of said pilot nano-structures, wherein said pilot-nanostructures formed in said writing layer represent a desired location and/or geometry of final nano-structures to be produced on a surface of said substrate, and wherein said pilot nano-structures comprise only a portion of a size of said final nano-structures;
c) transferring and enlarging said pilot nano-structures into said pattern transfer layer by applying a substantially isotropic etch selective for said pattern transfer layer to undercut said pattern transfer layer and create enlarged nano-structures in said pattern transfer layer at locations underneath said locations of said pilot nano-structures, wherein a diameter of said enlarged nano-structures in said pattern transfer layer is larger than a diameter of said pilot nano-structures in said writing layer, the enlarged nano-structures comprising at least one of nano-holes, nano-slots and nano-grooves;
d) undercutting said lift-off layer using a lift-off etch selective for said lift-off layer to create enlarged lift-off structures in said lift-off layer beneath the locations of said enlarged nano-structures in said pattern transfer layer to reveal said substrate underneath said locations of said enlarged nano-structures in said pattern transfer layer;
e) removing said writing layer to reveal said enlarged nano-structures in said pattern transfer layer; and
f) after removing said writing layer, applying a directional anisotropic etch to said substrate through said enlarged nano-structures in said pattern transfer layer to produce enlarged nano-structures in said surface of said substrate at locations underneath said locations of said enlarged nano-structures in said pattern transfer layer, wherein said enlarged nano-structures in said surface of said substrate comprise said final nano-structures.

The above-described method may optionally further comprise the step of:
g) removing said lift-off layer and said pattern transfer layer to reveal said final enlarged nano-structures etched into said substrate.

### BRIEF DESCRIPTION OF THE DRAWINGS

Several embodiments of the present invention will now be described with reference to the accompanying drawing figures, in which:
FIG. 1 illustrates a perspective schematic view of a pattern writing step of a method of fabrication for manufacturing nano-structures according to an embodiment of the present invention.
FIG. 2 illustrates a perspective schematic view of an exemplary completed surface nano-structure manufactured according to an embodiment of the present invention.
FIG. 3A illustrates a cross-sectional schematic view of a pre-fabrication substrate comprising pattern layers, prepared according to an embodiment of the present invention.
FIG. 3B illustrates a top schematic view of the pre-fabrication substrate shown in FIG. 3A, according to an embodiment of the present invention.
FIG. 4A illustrates a cross-sectional schematic view of a pattern writing step of a method of fabrication for manufacturing nano-structures according to an embodiment of the present invention.
FIG. 4B illustrates a top schematic view of the pattern writing step illustrated in FIG. 4A, according to an embodiment of the present invention.
FIG. 5A illustrates a cross-sectional schematic view of a pattern transfer step of a method of fabrication for manufacturing nano-structures according to an embodiment of the present invention.
FIG. 5B illustrates a top schematic view of the pattern transfer step illustrated in FIG. 5A, according to an embodiment of the present invention.
FIG. 6A illustrates a cross-sectional schematic view of a lift-off layer undercutting step of a method of fabrication for manufacturing nano-structures according to an embodiment of the present invention.
FIG. 6B illustrates a top schematic view of the lift-off layer undercutting step illustrated in FIG. 6A, according to an embodiment of the present invention.
FIG. 7A illustrates a cross-sectional schematic view of a writing layer removal step of a method of fabrication for manufacturing nano-structures according to an embodiment of the present invention.
FIG. 7B illustrates a top schematic view of the writing layer removal step illustrated in FIG. 7A, according to an embodiment of the present invention.
FIG. 8A illustrates a cross-sectional schematic view of a positive mask deposition step of a method of fabrication for manufacturing nano-structures according to an embodiment of the present invention.
FIG. 8B illustrates a top schematic view of the positive mask deposition step illustrated in FIG. 8A, according to an embodiment of the present invention.
FIG. 9A illustrates a cross-sectional schematic view of a lift-off layer removal step of a method of fabrication for manufacturing nano-structures according to an embodiment of the present invention.
FIG. 9B illustrates a top schematic view of the lift-off layer removal step illustrated in FIG. 9A, according to an embodiment of the present invention.
FIG. 10A illustrates a cross-sectional schematic view of a substrate pattern transfer step of a method of fabrication for manufacturing nano-structures according to an embodiment of the present invention.
FIG. 10B illustrates a top schematic view of the substrate pattern transfer step illustrated in FIG. 10A, according to an embodiment of the present invention.
FIG. 11A illustrates a cross-sectional schematic view of a positive mask removal step of a method of fabrication for manufacturing nano-structures according to an embodiment of the present invention.
FIG. 11B illustrates a top schematic view of the positive mask removal step illustrated in FIG. 11A, according to an embodiment of the present invention.
FIG. 12 illustrates a top scanning electron microscope (SEM) view of pilot nano-structure patterns written according to an embodiment of the present invention.
FIG. 13A illustrates a top SEM view of exemplary nano-structure patterns enlarged in a pattern transfer layer according to an embodiment of the present invention.
FIG. 13B illustrates a cross-sectional schematic view of the enlarged nano-structure patterns illustrated in FIG. 13A, according to an embodiment of the present invention.
FIG. 14A illustrates a closeup perspective SEM view of enlarged nano-structures following a positive mask deposition step, according to an embodiment of the present invention.
FIG. 14B illustrates a perspective SEM view of the enlarged nano-structures illustrated in FIG. 14A following a positive mask deposition step, according to an embodiment of the present invention.
FIG. 15A illustrates a perspective SEM view of exemplary completed enlarged out of plane nano-structures manufactured according to an embodiment of the present invention.
FIG. 15B illustrates a closeup perspective SEM view of the exemplary completed enlarged out of plane nano-structures illustrated in FIG. 15A, according to an embodiment of the present invention.
FIG. 15C illustrates a closeup top SEM view of the exemplary completed enlarged out of plane nano-structures illustrated in FIG. 15A, according to an embodiment of the present invention.

Similar reference numerals are used to refer to similar features throughout the drawing figures.

### DETAILED DESCRIPTION OF SEVERAL EMBODIMENTS

In the present invention, an improved rapid method of fabrication is provided for producing nano-structures on substrate surfaces, in which one or more patterning or writing tools comprising electron-beam lithography tools are used to pattern only a portion of the final dimensions of the nano-structures desired to be produced. Accordingly, the amount of material to be patterned by the patterning or writing tool is reduced relative to other methods in which the full final dimensions of the desired nano-structures are required to be patterned by the patterning or writing tool. The relatively reduced use of the patterning or writing tool to produce any particular nano-structures in a substrate surface results in a reduction in at least one of the time and/or cost corresponding to the required use of the patterning or writing tool.

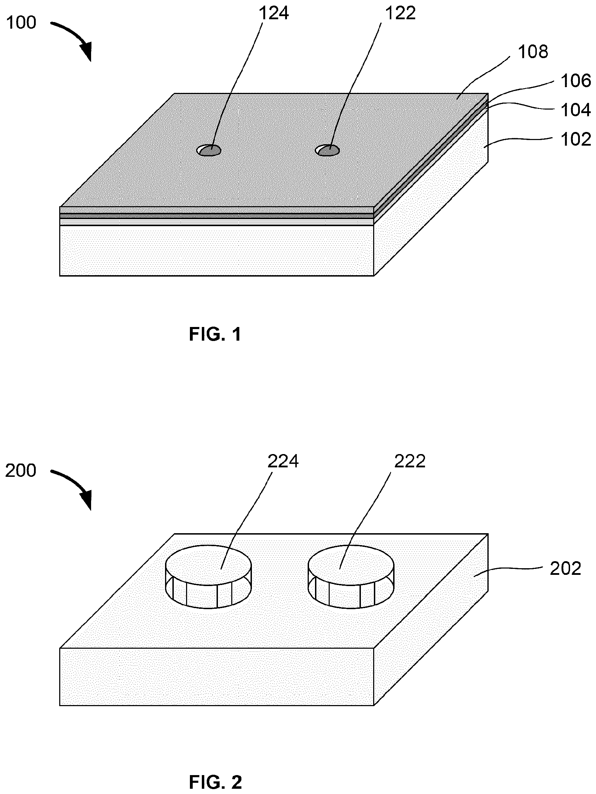

In a particular embodiment of the present invention directed to production of original nano-structures on a substrate surface such as for use as a die or stamp for imprinting and/or transfer of nano-structures to another imprintable medium, a method of fabrication of nano-structures according to the present invention is provided wherein a patterning or writing tool comprising an electron-beam lithography tool is used to pattern only a portion of the desired nano-structure features to be produced on the planar substrate surface, for example. In one such embodiment, the substrate surface desired to be patterned with original nano-structures may comprise a suitable known bulk substrate material, such as silicon, silicon based materials, quartz, other SiO₂ based materials, glass, polymers, resins, sapphire or other Al₂O₃ based materials, nickel, nickel containing alloys or other desirably stable and/or durable materials, for example. In an exemplary embodiment of the invention, original nano-structures may be produced on a substantially planar surface of an exemplary substrate material such as illustrated in FIGs. 1 and 2. In FIG. 1, a perspective schematic view of a pattern writing step of a method of fabrication for manufacturing nano-structures according to the present invention is shown, where an exemplary pre-fabrication substrate 100 comprising suitable process layers is provided for patterning of exemplary pilot nano-structures 122 and 124, for example. In FIG. 1, the substrate 100 comprises a base substrate material 102, and process layers suitable for patterning of the desired nano-structures, comprising a lift-off layer 104, a pattern transfer layer 106 and a writing layer 108 on which a patterning or writing tool is used to pattern the desired pilot nano-structures, such as exemplary pilot nano-structures 122 and 124. In the view shown in FIG. 1, an exemplary initial pattern writing step of a nano-structure manufacturing method according to the invention has been completed using an electron-beam lithography tool (and in some embodiments also including any required post-writing processing step such as a chemical processing step to remove writing layer material following writing or patterning), to produce openings in the writing layer 108 at the desired location of pilot nano-structures 122 and 124, and revealing the pattern transfer layer 106 beneath. In other embodiments, the substrate surface to be patterned may be non-planar, such as curved, faceted, irregular or other substantially non-planar surfaces, for example.

In FIG. 2, a perspective schematic view of an exemplary completed surface nano-structure manufactured according to the present invention is shown, wherein completed exemplary out of plane nano-pillar nano-structures 222 and 224 are shown, which correspond to the initial pilot nano-structures 122 and 124, respectively which are patterned on the writing layer 108 during the initial pattern writing step shown in FIG. 1. As can be seen by comparing the relative size of the initial patterned pilot nano-structures 122, 124 in the writing layer 108 with the completed pillar nano-structures 222, 224 in the completed substrate 202, the area and/or amount of material required to be patterned by an electron-beam lithography tool to create the initial pilot nano-structures 122, 124 represents only a portion of the amount of material which would be required to be removed (such as through ablation or milling away material around the completed nano-structures 222, 224) or retained (such as through inverse lithographic patterning of the entire top surface of completed nano-structures 222, 224) in order to pattern the entire size of the desired final nano-structures 222, 224. Accordingly, the use of an electron-beam lithography tool is reduced under a method of fabrication according to the present invention.

In one exemplary such embodiment, the substrate surface may be substantially planar. In other embodiments, the substrate surface to be patterned may be non-planar, such as curved, faceted, irregular or other substantially non-planar surfaces, for example

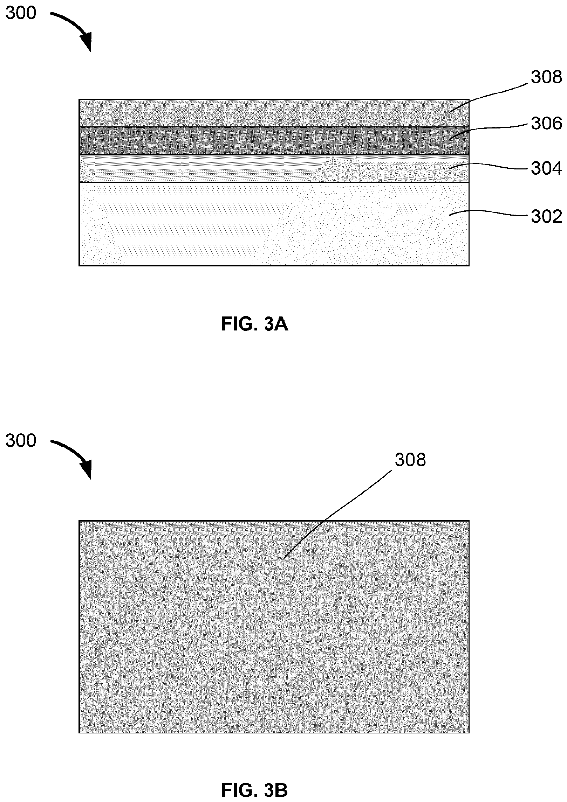

Referring now to FIGs. 3A and 3B, FIG. 3A illustrates a cross-sectional schematic view of a pre-fabrication substrate 300 comprising pattern layers, prepared according to the present invention, and FIG. 3B illustrates a top schematic view of the pre-fabrication substrate 300 shown in FIG. 3A, according to the present invention. In FIG. 3A, the pre-fabrication substrate 300 comprises a substrate base material 302, and process material layers comprising a lift-off material layer 304, a pattern transfer layer 306 and a writing layer 308 arranged sequentially on top of the substrate material 302, which are provided in a first step of a method of fabrication according to the present invention. As shown in FIG. 3B, in one embodiment the process material layers may desirably cover substantially the entire surface of the substrate 302 that is intended to be patterned with nano-structures, so as to provide a consistent surface for application of fabrication process steps as described above and detailed below.

In one embodiment, the base substrate material 302 may comprise any suitable substrate material providing suitable stability and durability for use as a master die or shim on which original nano-structures may be formed. Exemplary such suitable substrate materials 302 may comprise one or more of: silicon, silicon based materials, quartz (such as fused quartz), other SiO₂ based materials, glass, resins, sapphire or other Al₂O₃ based materials, nickel or nickel containing alloys, other suitable metals and/or alloys and some suitably stable and durable polymer and composite materials, for example. Similarly, lift-off material layer 304 may comprise any suitable lift-off material known in the art which is desirably compatible with the substrate material layer 302 and suitable for adherent uniform application (such as by a suitable coating (such as spin-coating), or deposition technique (such as physical vapor deposition (PVD), chemical vapor deposition (CVD), plasma-enhanced chemical vapor deposition (PECVD), molecular beam epitaxy (MBE), atomic layer deposition, or laser ablation), for example) to the substrate 302, and is desirably also selectively removable from the substrate 302 by use of one or more selective chemical, physical, or thermal agents or processes, for subsequent removal from the substrate material 302 during subsequent process steps.

In one embodiment, potential suitable such lift-off materials 304 may comprise one or more materials and/or sublayers and may comprise one or more materials known in the art of nanolithographic processing, such as in an exemplary embodiment one or more suitable materials selected from the list comprising: metals (such as but not limited to Pt, In, Cr, Ni, Ti, Ag, Au, Al, Cu for example), alloys thereof and of other metallic materials, polymers, organic polymers (such as but not limited to PMMA (poly(methyl methacrylate)) and PMGI (polymethylglutarimide) for example), polystyrene (PS), SU8, photoresist, silicon, SiO₂, TiO₂, indium tin oxide (ITO), poly(ethylene) carbonate (PEC), poly(acrylic) acid, and silicone/siloxane based materials, for example, wherein the selected lift-off material 304 is compatible with the selected substrate 302 and subsequent pattern transfer layer 306 and writing layer 308 materials so as to allow for selective etching and/or removal of the lift-off material 304. In another embodiment, the thickness of the lift-off layer 304 may desirably be selected to be within a range of the dimensions of the desired nano-structures, and in a further embodiment may also desirably be within an acceptable thickness range for desired positive mask material to be deposited during a positive mask deposition step. In a particular embodiment, lift-off layer 304 may comprise a 50 nm thick layer of at least one such suitable lift-off layer material, for example.

In one embodiment, pattern transfer material 306 may comprise any material suitable for adherent application (such as by a suitable coating (such as spin-coating), or deposition technique (such as physical vapor deposition (PVD), chemical vapor deposition (CVD), plasma-enhanced chemical vapor deposition (PECVD), molecular beam epitaxy (MBE), atomic layer deposition, or laser ablation), for example) to lift-off layer 304, and which is selectively etched, such as by one or more chemical, gaseous, or plasma etchants, so as to allow for controllable progressive enlargement of nano-structure patterns by such etchant in subsequent process steps. The etch process applied to enlarge nano-structure patterns in the pattern transfer layer 306 comprises a substantially isotropic etching process, such as substantially isotropic etch processes employing one or more of: wet chemical, gaseous, plasma, reactive ion, xenon fluoride (XeF₂), electron cyclotron resonance (ECR), inductively coupled plasma (ICP) and plasma enhanced reactive ion (PERIE) etchants, for example.

In one such embodiment, pattern transfer material layer 306 may comprise one or more materials and/or sublayers and may comprise one or more materials known in the art of nanolithographic processing, and may be selected from the list comprising: metals (such as but not limited to Pt, In, Cr, Ni, Ti, Ag, Au, Al, Cu for example), alloys thereof and of other metallic materials, polymers, organic polymers (such as but not limited to PMMA (poly(methyl methacrylate)) and PMGI (polymethylglutarimide) for example), polystyrene (PS), SU8, photoresist, silicon, SiO₂, TiO₂, indium tin oxide (ITO), poly(ethylene) carbonate (PEC), poly(acrylic) acid, and silicone/siloxane based materials, for example, wherein the selected pattern transfer material 306 is compatible with the selected lift-off 304 and substrate 302 and subsequent writing layer 308 materials, so as to provide for selective etching suitability. In another embodiment, the thickness of the pattern transfer layer 306 may desirably be selected to be suitable for a desired enlargement of pilot nano-structures within the pattern transfer layer 306, by substantially isotropic etching of the pattern transfer layer 306. In a particular embodiment, pattern transfer layer 306 may comprise a 50 nm layer of Cr, for example.

In the invention the writing material comprises a photoresist or an electron-beam resist material, which may be suitably patterned by an electron-beam lithography tool, to pattern pilot nano-structures in the writing layer 308 to reveal the underlying pattern transfer layer 306 in a subsequent writing step of a method of fabrication described in further detail below. In another such embodiment, the writing material layer 308 may comprise a positive nanolithographic mask or photoresist mask material which may be exposed by an electron-beam lithography tool to expose pilot nano-structure patterns on the writing material 308 which are subsequently developed by a suitable known compatible positive mask or photoresist development agent to form pilot nano-structures in the writing material 308 and expose the pattern transfer layer 306 below.

In one such embodiment, writing material layer 308 may comprise one or more materials and/or sublayers and may comprise one or more suitable materials known in the art of nanolithographic processing, wherein the selected writing material 308 is compatible with an electron-beam lithography tool, and with the selected underlying pattern transfer layer 306 material, lift-off 304 and substrate 302 materials, such as to provide for selective etching of the writing material layer 308. In one embodiment, the writing material 308 may be selected from polymers, organic polymers (such as but not limited to PMMA (poly(methyl methacrylate)) and PMGI (polymethylglutarimide) for example), copolymer P(MMA-MAA), EBR-9, ZEP resist materials such as ZEP-520, UV-3, UV-5 or Apex-E resist materials, Si/silicone/siloxane materials, and composites, for example, wherein the selected writing material 308 is compatible with an electron-beam lithography tool, and with the selected underlying pattern transfer layer 306, lift-off layer 308, and substrate 302 materials. In one embodiment, the thickness of writing layer 308 may be desirably selected so as to provide adequate protection of underlying material layers during patterning or writing steps, while also desirably providing for patterning of the writing layer by an electron-beam lithography tool at a desirably low dose or intensity and desirably small beam dimension of the patterning or writing tool such as to desirably reduce required time for use of the tool to pattern pilot nano-structures in the writing layer 308, for example. In a particular embodiment, writing layer 308 may comprise a 50 nm layer of at least one such suitable writing layer material.

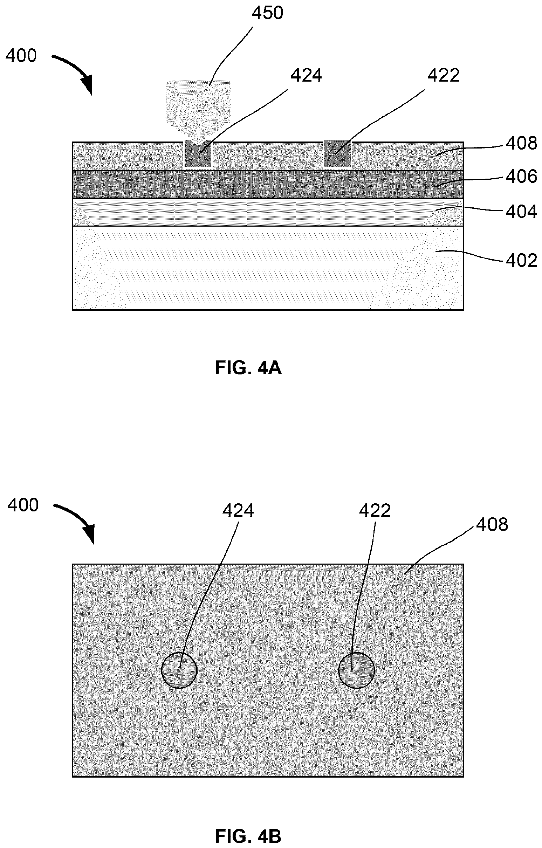

Referring now to FIGs. 4A and 4B, FIG. 4A illustrates a cross-sectional schematic view of a pattern writing step 400 of a method of fabrication for manufacturing nano-structures on a planar surface of a substrate 402, according to an embodiment of the present invention. FIG. 4B illustrates a top schematic view of the pattern writing step 400 illustrated in FIG. 4A, according to an embodiment of the present invention. In the embodiment illustrated in FIGs. 4A and 4B, a suitable substrate 402 comprising process layers which comprise lift-off layer 404, pattern transfer layer 406 and writing layer 408 is provided as described in the first step of the method of fabrication as detailed above with reference to FIGs. 3A and 3B. In the pattern writing step 400, a suitable patterning or writing tool 450 is used to pattern pilot nano-structures 422 and 424 in the writing layer 408, in order to reveal the pattern transfer layer 406 underneath the writing layer 408 at the location of the pilot nano-structures 422, 424. In the present invention, the pilot nano-structures 422, 424 may desirably represent small initial or pilot nano-structure features which are formed in the writing layer 408 using the patterning or writing tool 450, and which represent the desired location and/or geometry of the intended final nano-structures desired to be produced by the method of fabrication. The pilot nano-structures 422, 424 patterned in the pattern writing step 400 are substantially smaller than the intended final nano-structures, such that the amount of time and/or exposure or dose required by the patterning or writing tool 450 to pattern the pilot nano-structures 422, 424 is substantially less than would be required in order to pattern the entire size and shape of the intended final nano-structures, such as to reduce the time and/or cost associated with use of the tool 450 during the pattern writing step 400.

The patterning or writing tool 450 comprises an electron beam lithography (EBL) tool 450 which is suitable to write patterns at a desired nano-scale by exposure of a suitable photoresist or nanolithographic resist material forming the writing layer 408, for example. In one such embodiment, the writing material layer 408 may comprise a positive photoresist or nanolithographic resist material and may be developed by a suitable positive resist developer to remove the pilot nano-structures 422, 424 patterned by the exposure of the tool 450, and to leave pilot nano-structures 422, 424 in the writing layer 408 and reveal the pattern transfer layer 406 beneath. In another embodiment, the writing material layer 408 may comprise a negative photoresist or nanolithographic resist material such that the pilot nano-structures patterned in the writing layer 408 are retained following development by a suitable negative resist developer to remove the unexposed/unpatterned material surrounding the desired pilot nano-structures, for example. Tool 450 comprises an EBL tool 450 such as a Raith eLine ^{™} EBL system, for example, and writing layer 408 may be selected from known positive resist materials such as one or more polymeric positive resist materials such as PMMA, copolymer P(MMA-MAA), PMGI, EBR-9 resist material, ZEP resist materials, UV-3, UV-5 or Apex-E resist materials, for example, such that during writing step 400 desired pilot nano-structures 422, 424 are patterned by the EBL tool 450 and developed by a suitable positive resist developer to form pilot nano-structures 422, 424 in writing layer 408 revealing pattern transfer layer 406 beneath.

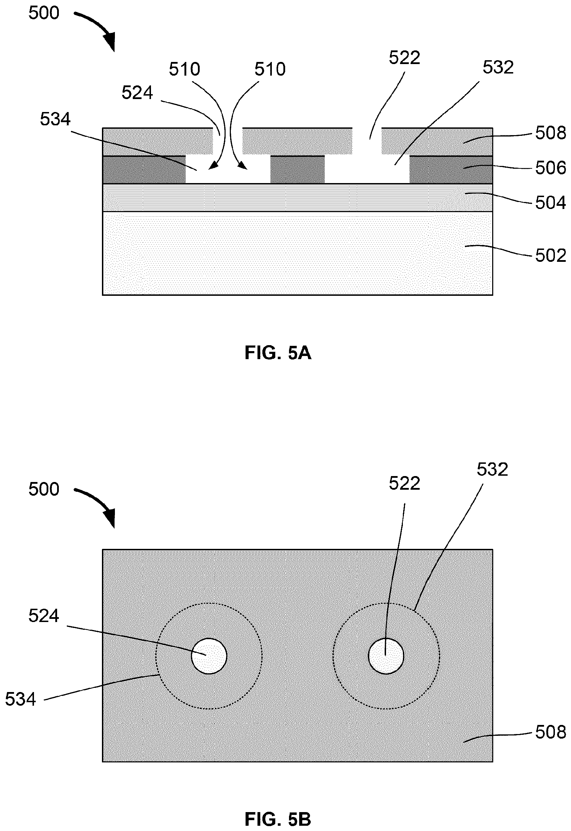

Referring now to FIGs. 5A and 5B, FIG. 5A illustrates a cross-sectional schematic view of a pattern transfer step 500 of a method of fabrication for manufacturing nano-structures according to an embodiment of the present invention. FIG. 5B illustrates a top schematic view of the pattern transfer step 500 illustrated in FIG. 5A, according to an embodiment of the present invention. In the embodiment illustrated in FIGs. 5A and 5B, a suitable substrate 502 comprising process layers which comprise lift-off layer 504, pattern transfer layer 506 and writing layer 508 is provided and exemplary pilot nano-structures 522, 524 are patterned in the writing layer 508 as described in the first two steps 300, 400, of the method of fabrication as detailed above with reference to FIGs. 3A - 4B. In the pattern transfer step 500 of FIGs. 5A and 5B, the pilot nano-structures 522, 524 are transferred and enlarged into the pattern transfer layer 506 by controlled application of a suitable substantially isotropic etchant 510 selective for the pattern transfer layer material 506. The pattern transfer layer 506 is exposed to the substantially isotropic selective etchant 510 through the pilot nano-structures 522, 524 and the selective etchant acts to transfer and enlarge the nano-structures on the pattern transfer material 506 at the locations of the pilot nano-structures 522, 524 by removal of the pattern transfer material 506 and undercutting the edges of the pilot nano-structures 522, 524 to form enlarged nano-structures 532, 534 in the pattern transfer material 506. In such an embodiment, the controlled substantially isotropic etch may comprise any suitable substantially isotropic etchant 510 which is selective for removal of the pattern transfer layer material 506 over writing layer material 508 and lift-off layer material 504, and preferably also over substrate material 502, for example.

In one such embodiment, the controlled substantially isotropic etch may comprise a suitable selective etchant 510 which acts substantially isotropically in the pattern transfer material 506 to remove the pattern transfer material 506 substantially equally in all directions away from the pilot nano-structures 522, 524 through the writing layer 508. In such an embodiment, the geometry of the enlarged nano-structures 532, 534 undercut in the pattern transfer layer 506 may desirably be substantially similar to the geometry of the pilot nano-structures 522, 524 patterned in the writing layer 508, as illustrated in the exemplary embodiment shown in FIG. 5B, for example.

In another embodiment, the controlled substantially isotropic etch may desirably comprise a suitable selective substantially isotropic etchant 510 which acts to remove the pattern transfer layer material 506 according to a defined rate of etching, such that the extent of undercutting of the pattern transfer layer material 506 by the etchant 510 may be desirably controlled. In such an embodiment, the substantially isotropic etch may desirably be controlled by at least one controllable parameter such as concentration or quantity of etchant 510, temperature of etch, time of etch and/or measureable/detectable extent of etch, which may be controlled by an operator or automated means during application of etchant 510. In such case, the pattern transfer and enlargement step of a method of fabrication may be desirably controlled to enlarge pilot nano-structures 522, 524 in writing layer 508 by a desired factor or extent, such as to result in a desired dimension and/or geometry of enlarged nano-structures 532, 534 in pattern transfer layer 506, for example.

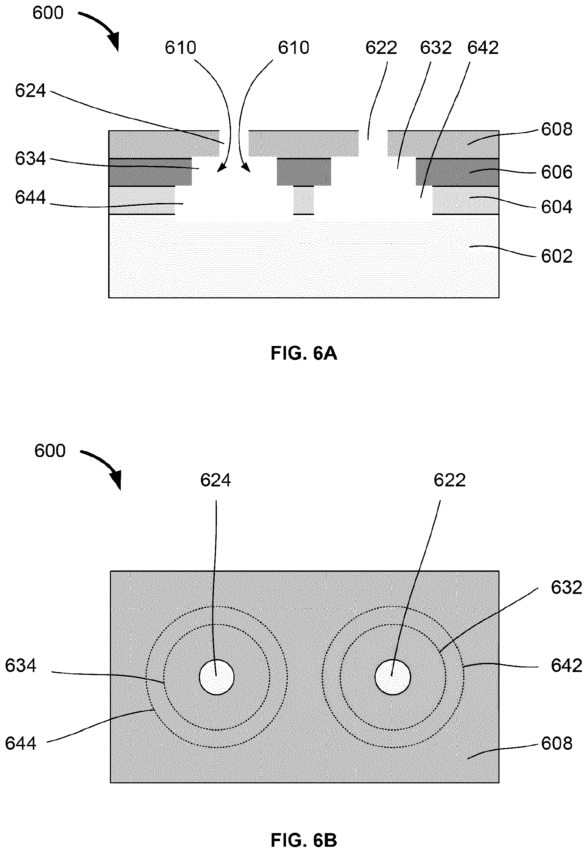

Referring now to FIGs. 6A and 6B, FIG. 6A illustrates a cross-sectional schematic view of a lift-off layer undercutting step 600 of a method of fabrication for manufacturing nano-structures according to an embodiment of the present invention. FIG. 6B illustrates a top schematic view of the lift-off layer undercutting step 600 illustrated in FIG. 6A, according to an embodiment of the present invention. In the embodiment illustrated in FIGs. 6A and 6B, a suitable substrate 602 comprising process layers which comprise lift-off layer 604, pattern transfer layer 606 and writing layer 608 is provided and exemplary pilot nano-structures 622, 624 are patterned in the writing layer 608 and enlarged nano-structures 632, 634 are transferred into the pattern transfer layer 606, as described in the first three steps 300, 400, and 500 of the method of fabrication as detailed above with reference to FIGs. 3A - 5B. In the lift-off layer undercutting step 600 of FIGs. 6A and 6B, the desired enlarged nano-structures 632, 634 in the pattern transfer layer 606 are further transferred and enlarged into the lift-off layer 604, so as to undercut the enlarged nano-structures 632, 634 in pattern transfer layer 606 above, and create undercut lift-off structures 642, 644 in the lift-off layer 604 by controlled application of a suitable lift-off undercut etchant 610 selective for the lift-off layer material 604. The lift-off layer 604 is exposed to the lift-off selective etchant 610 through the enlarged nano-structures 632, 634 and the selective etchant acts to undercut lift-off layer 604 at the locations of the enlarged nano-structures 632, 634 by removing the lift-off material 604 to form undercut lift-off structures 642, 644 in the lift-off material 604.

In such an embodiment, the controlled lift-off undercutting etch may comprise any suitable etchant 610 which is selective for removal of the lift-off layer material 604 over writing layer, pattern transfer layer 606 and substrate layer 602 materials, for example. In one such embodiment, the controlled lift-off undercutting etch may comprise a suitable selective etchant 610 which acts substantially isotropically in the lift-off material 604 to undercut the lift-off material 604 substantially equally in all directions away from the enlarged nano-structures 632, 634 in the pattern transfer layer 606, as illustrated in the exemplary embodiment shown in FIG. 6B, for example. In an alternative embodiment, the controlled lift-off undercutting etch may comprise a suitable selective lift-off etchant 610 which acts in at least a partially isotropic manner in the lift-off material 604, so as to undercut the lift-off material 604 at least partially isotropically away from the enlarged nano-structures such as 632, 634.

In another embodiment, the controlled lift-off undercutting etch may desirably comprise a suitable selective etchant 610 which acts to remove the lift-off layer material 604 according to a defined rate of etching, such that the extent of undercutting of the lift-off layer 604 by the etchant 610 may be desirably controlled. In such an embodiment, the lift-off undercutting etch may desirably be controlled by at least one controllable parameter such as concentration and/or quantity of etchant 610, temperature of etch, time of etch and/or measureable/detectable extent of etch, which may be controlled by an operator or automated means during application of etchant 610. In such case, the lift-off undercutting step of a method of fabrication may be desirably controlled to provide a desired dimension and/or geometry of lift-off structures 642, 644 in lift-off layer 604. In a particular embodiment, lift-off undercutting may be desirably controlled to provide a suitable undercut profile in lift-off layer 604 such as to provide for effective separation of lift-off layer 604 from enlarged nano-structures 632, 634 in pattern transfer layer 606 above so as to allow deposition of a mask material onto substrate material 602 without contacting lift-off material 604 within lift-off structures 642, 644, for example.

In an optional embodiment, lift-off undercutting step 600 may additionally comprise a further sub-step in which a preliminary etch may be applied to lift-off layer material 604 prior to the application of an at least partially isotropic selective lift-off undercut etchant 610, for example. In one such optional embodiment, the preliminary etch may comprise a substantially isotropic or a non-isotropic etch comprising application of a suitable etchant to etch at least a portion of the lift-off layer material 604 exposed through enlarged nano-structures 632, 634, so as to remove at least a portion of such lift-off layer material prior to the undercutting at least partically isotropic lift-off etch using etchant 610 as described above. In a particular such embodiment, the preliminary etchant may be applied so as to act in at least one of a substantially isotropic manner in all directions, in a direction parallel to the surface of substrate 602, and/or in a direction perpendicular to the surface of substrate 602, so as to etch at least a portion of lift-off material layer 604 prior to the application of at least partially isotropic lift-off 1 undercutting etchant 610 to undercut lift-off layer 604, as described above.

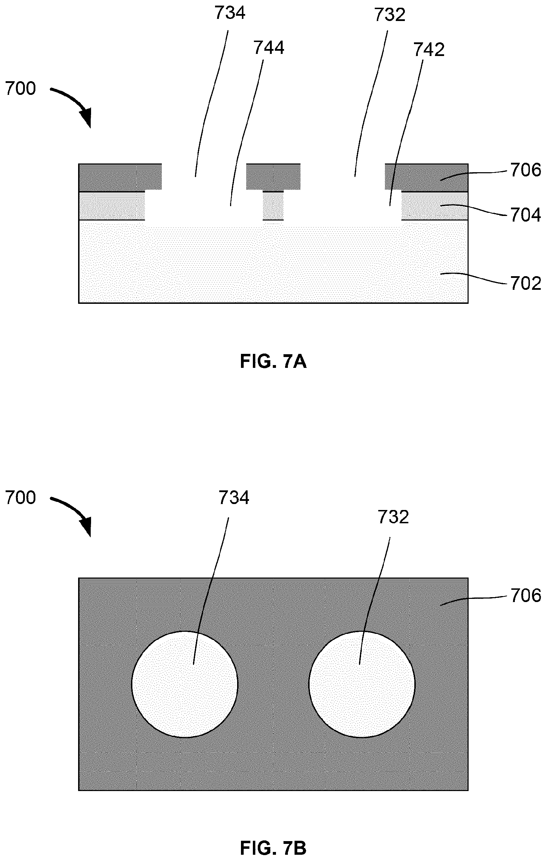

Referring now to FIGs. 7A and 7B, FIG. 7A illustrates a cross-sectional schematic view of a writing layer removal step 700 of a method of fabrication for manufacturing nano-structures according to an embodiment of the present invention. FIG. 7B illustrates a top schematic view of the writing layer removal step 700 illustrated in FIG. 7A, according to an embodiment of the present invention. In the embodiment illustrated in FIGs. 7A and 7B, following the lift-off undercutting step 600 shown in FIGs. 6A and 6B, a writing layer (shown as 608 in FIGs. 6A and 6B) is removed from the substrate 702 and process layers, leaving substrate 702, lift-off layer 704 and pattern transfer layer 706. Desired enlarged nano-structures 732, 734 are thereby revealed in pattern transfer layer 706, with enlarged lift-off structures 742, 744 remaining in lift-off layer 704 beneath, while the pilot nano-structures originally patterned in the writing layer (shown as 608 in FIGs. 6A and 6B) are removed in order to reveal the desired enlarged nano-structures 732, 734.

In one embodiment, the removal of a writing layer from pattern transfer layer 706 may be accomplished by any suitable chemical, thermal and/or physical means, and in a particular embodiment may be accomplished by application of a suitable wet chemical, gaseous and/or plasma etchant or solvent selective for the writing layer material over the pattern transfer layer 706, lift-off layer 704 or substrate 702 materials, for example.

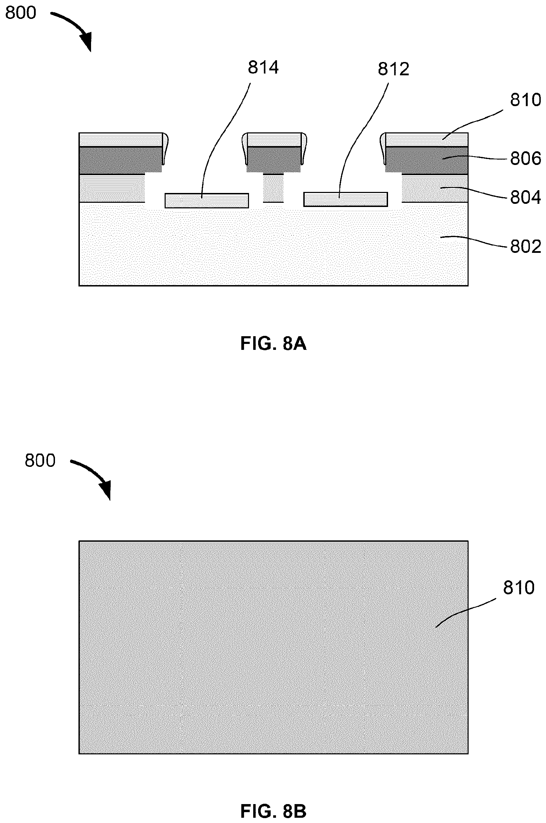

Referring now to FIGs. 8A and 8B, FIG. 8A illustrates a cross-sectional schematic view of a positive mask deposition step 800 of a method of fabrication for manufacturing nano-structures according to an embodiment of the present invention. FIG. 8B illustrates a top schematic view of the positive mask deposition step 800 illustrated in FIG. 8A, according to an embodiment of the present invention. In the embodiment illustrated in FIGs. 8A and 8B, a positive mask deposition step 800 may comprise application and/or deposition of a suitable positive mask material 810 on top of an exposed pattern transfer layer 806 and underlying undercut lift-off layer 804 and substrate 804. In one such embodiment, a suitable positive mask material 810 may be applied or deposited by any suitable known means on top of pattern transfer layer 806, such as by coating (such as spin-coating), deposition (such as physical vapor deposition (PVD), chemical vapor deposition (CVD), plasma-enhanced chemical vapor deposition (PECVD), molecular beam epitaxy (MBE), atomic layer deposition, or laser ablation, for example, so as to produce a substantially uniform layer of positive mask material 810 and to apply/deposit mask material as enlarged positive mask nano-structures 812, 814 on exposed substrate 802. In one such embodiment, enlarged positive mask nano-structures 812, 814 may desirably conform to the size and geometry of desired enlarged nano-structures in pattern transfer layer 806 so as to provide for substantially faithful reproduction of pattern transfer layer nano-structures in enlarged positive mask nano-structures 812, 814 on substrate 802.

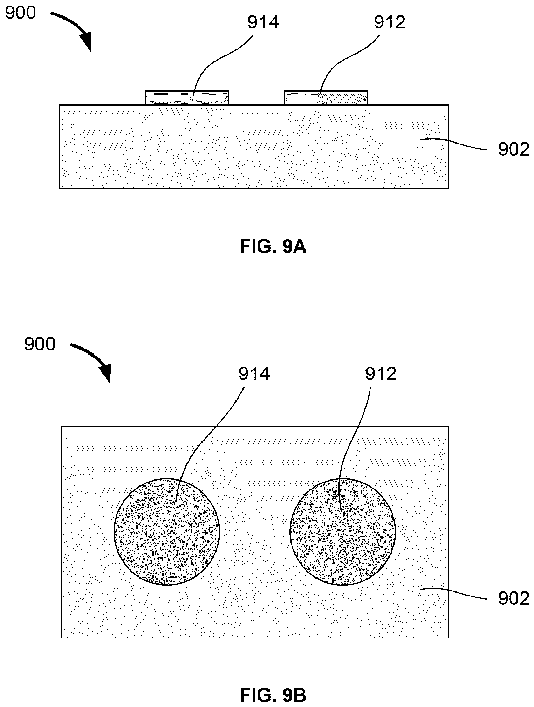

Referring now to FIGs. 9A and 9B, FIG. 9A illustrates a cross-sectional schematic view of a lift-off layer removal step 900 of a method of fabrication for manufacturing nano-structures according to an embodiment of the present invention. FIG. 9B illustrates a top schematic view of the lift-off layer removal step 900 illustrated in FIG. 9A, according to an embodiment of the present invention. In the embodiment illustrated in FIGs. 9A and 9B, following the positive mask material deposition step 800 shown in FIGs. 8A and 8B, a lift-off layer (shown as 804 in FIG. 8A) is removed from the substrate 802, and remaining process layers on top of the lift-off layer (such as pattern transfer layer 806 and positive mask material layer 810) are removed along with the lift-off layer, leaving substrate 902, and positive enlarged nano-structures 912, 914 on substrate 902. Desired enlarged positive nano-structures 912, 914 are thereby revealed on the surface of substrate 902, while the remaining process layer materials are removed.

In one embodiment, the removal of a lift-off layer 804 (and all remaining process layer materials on top of the lift-off layer) may be accomplished by any suitable chemical, thermal and/or physical means, and in a particular embodiment may be accomplished by application of a suitable wet chemical, gaseous and/or plasma etchant or solvent selective for the lift-off layer material over the substrate 902 or positive mask materials comprising the positive enlarged nano-structures 912, 914, for example.

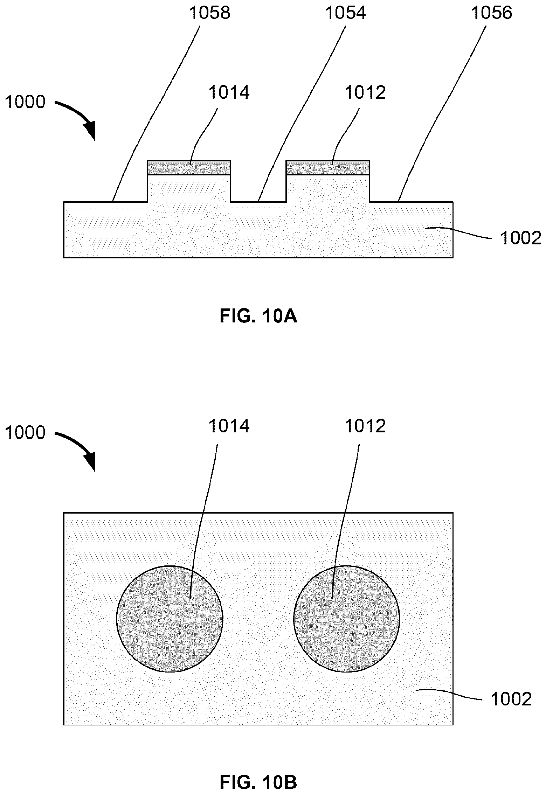

Referring now to FIGs. 10A and 10B, FIG. 10A illustrates a cross-sectional schematic view of a substrate pattern transfer step 1000 of a method of fabrication for manufacturing nano-structures according to an embodiment of the present invention. FIG. 10B illustrates a top schematic view of the substrate pattern transfer step 1000 illustrated in FIG. 10A, according to an embodiment of the present invention. In the FIGs. 10A and 10B, following the lift-off layer removal step 900 described above, a suitable directional anisotropic etch is applied in a substrate pattern transfer step 1000, such as to etch directionally into the substrate material 1002 surrounding positive mask nano-structures on the substrate surface, so as to etch away exemplary etched substrate areas 1054, 1056 and 1058 surrounding the enlarged positive mask nano-structures 1012, 1014 leaving desired out of plane enlarged nano-structures 1012, 1014.

In one embodiment, the directional anisotropic etch may comprise a reactive ion etch (RIE) comprising application of a suitable reactive ion etchant to the surface of the substrate 1002. In one such embodiment the suitable reactive ion etchant may desirably provide a direction of etch directed normal to the surface of the substrate 1002 such as to etch downward (as represented in FIG. 10A) into the substrate 1002 to produce upwardly extending out of plane enlarged nanostructures 1012, 1014, for example. In a particular embodiment, the RIE may comprise any suitable etchant compatible with the substrate and positive mask materials, such as to enable selective directional etching of the substrate material 1002 over the positive mask material, such that the resulting out of plane enlarged nano-structures 1012, 1014 substantially conform to the dimensions and geometry of the enlarged positive mask nano-structures 912, 914, as they were transferred from the original enlarged nano-structures 732, 734 in the pattern transfer layer in previous process steps as described above. In another particular embodiment, a suitable RIE applied in substrate pattern transfer step 1000 may desirably comprise a controllable directional anisotropic etch wherein the extent of directional etching of the substrate material 1002 may desirably be controlled such as to select a desired out of plane dimension of desired out of plane enlarged nano-structures 1012, 1014, for example. In another embodiment, the directional anisotropic etch may comprise at least one of an ECR, ICP, RIE and PERIE etch process, or combinations thereof.

In one embodiment of the present invention, substrate pattern transfer step 1000 may comprise a final step of a method for fabrication for manufacturing enlarged nano-structures. In such an embodiment, raised out of plane enlarged nano-structures 1012, 1014 may comprise the desired final enlarged nano-structures to be produced on the surface of substrate 1002, and substrate 1002 comprising such enlarged nano-structures may consequently be used as a nano-structure shim or stamp, such as for nano-imprinting, for example.

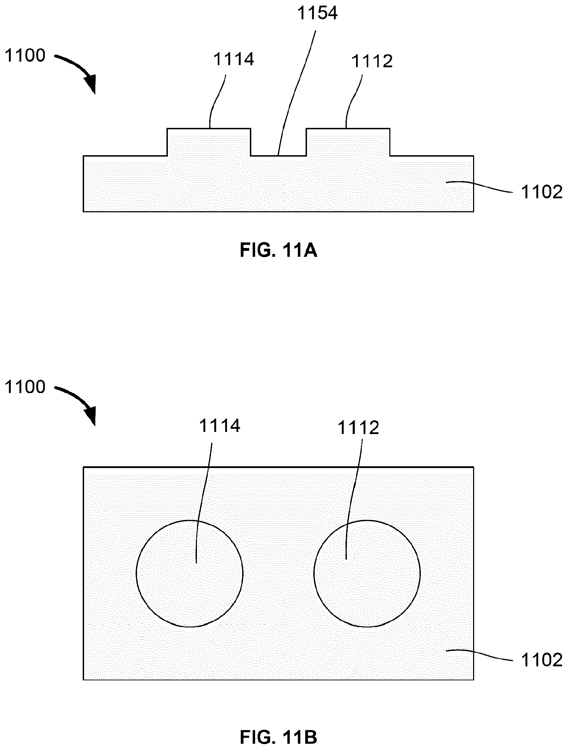

In another optional embodiment of the present invention, a method of fabrication for manufacturing nano-structures may additionally comprise a further optional positive mask removal step 1100, such as illustrated in FIGs. 11A and 11B. In such an optional embodiment, FIG. 11A illustrates a cross-sectional schematic view of a positive mask removal step 1100 and FIG. 11B illustrates a top schematic view of the positive mask removal step 1100 illustrated in FIG. 11A. In the optional embodiment illustrated in FIGs. 11A and 11B, following the substrate pattern transfer step 1000 shown in FIGs. 10A and 10B, a positive mask material layer comprising enlarged positive mask nano-structures (shown as 912, 914 in FIG. 9A) is removed from the substrate 1102, leaving substrate 1102 and final out of plane enlarged pillar-shaped nano-structures 1112, 1114 on substrate 1102, with lower inter-structure portion 1154 of the surface of substrate 1102 located between the nano-structures 1112, 1114, such as illustrated in FIGs. 11A and 11B. Desired final out of plane enlarged pillar-shaped nano-structures 1112, 1114 are thereby exposed on the surface of substrate 1102, such as for use in nano-imprinting or other processes requiring the desired enlarged nano-structures.

In one embodiment, the removal of a positive mask layer comprising positive mask enlarged nanostructures 912, 914 may be accomplished by any suitable chemical, thermal and/or physical means, and in a particular embodiment may be accomplished by application of a suitable wet chemical, gaseous and/or plasma etchant or solvent selective for the positive mask layer material over the substrate 1102, for example.

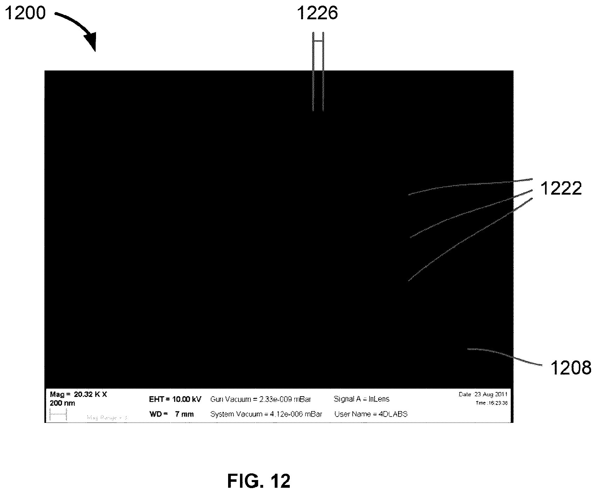

Referring now to FIG. 12, a top scanning electron microscope (SEM) view 1200 of exemplary pilot nano-structure patterns written according to an embodiment of the present invention are shown. Pilot nano-structures 1222 are shown arranged in a regular grid pattern such as following a pattern writing step 400 of a method of fabrication as detailed above with reference to FIGs. 4A and 4B, for example. The pilot nano-structures 1222 have substantially uniform pilot diameter 1226, corresponding to the scale of the feature written by the patterning or writing tool used in the pattern writing step. Pilot nano-structures 1222 comprise openings in a writing layer 1208 of the substrate and process layers applied to the substrate, such as shown in FIGs. 4A and 4B, for example. In a particular embodiment, the regular grid of pilot nano-structures 1222 with regular spaces between pilot nano-structures, where the dimensions of the spaces are greater than the diameter of the pilot nano-structures, may be desirable for producing a regular array of completed enlarged nano-structures following later process steps, for example. Pilot nano-structures 1222 may be written in an exemplary positive photoresist writing layer material 1208 by use of an EBL tool with subsequent development of the writing layer resist 1208 to expose an underlying pattern transfer layer at the locations of the pilot nano-structures 1222. In a particular such embodiment, the pilot diameter 1226 of the exemplary pilot nano-structures 1222 may be approximately 100 nm, as may be desirable for relatively rapid patterning or writing of the pilot nano-structures using a conventional EBL tool, for example.

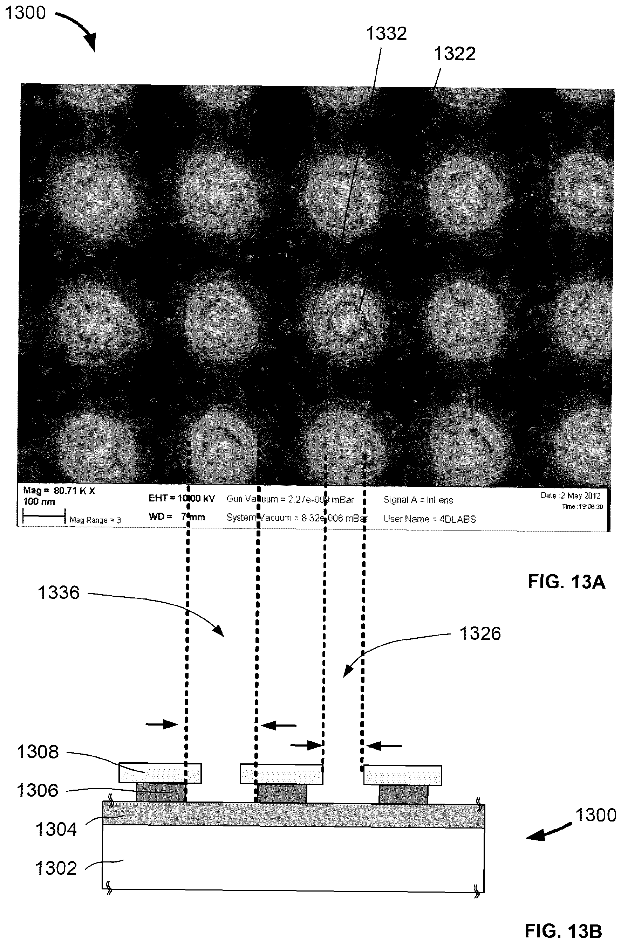

Referring now to FIGs. 13A and 13B, FIG. 13A illustrates a top SEM view 1300 of exemplary enlarged nano-structures 1332 which are enlarged in a pattern transfer layer 1306 relative to the smaller pilot nano-structures 1322 in a writing layer 1308, according to the present invention. FIG. 13B illustrates a cross-sectional schematic view of the enlarged nano-structures 1332 in pattern transfer layer 1306 centered at the same locations as smaller exemplary pilot nano-structures 1322 in the writing layer 1308, according to the present invention. Enlarged nano-structures 1332 in pattern transfer layer 1306 have enlarged diameter 1336 which is substantially larger than a pilot diameter 1326 of exemplary pilot nano-structures 1322 in writing layer 1308.

In the present invention, the enlarged nano-structures 1332 in pattern transfer layer 1306 are produced by a pattern enlargement step such as that described above with reference to FIGs. 5A and 5B, using a substantially isotropic etch to undercut and enlarge nano-structures 1332 in pattern transfer layer 1306. In a particular embodiment, the enlarged diameter 1336 of exemplary enlarged nano-structures 1332 in pattern transfer layer 1306 may be approximately 400 nm, while the pilot diameter 1326 of exemplary pilot nano-structures 1322 in writing layer 1308 may be about 100 nm, for example. Enlarged nano-structures 1332 in pattern transfer layer 1306 reveal the lift-off layer 1304 underlying the pattern transfer layer 1306.

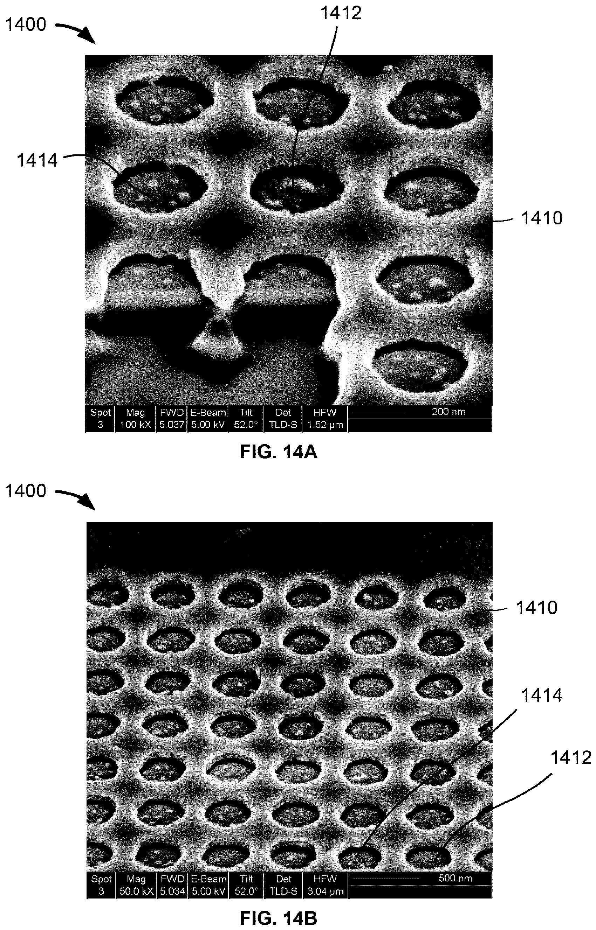

Referring now to FIGs. 14A and 14B, FIG. 14A illustrates a closeup perspective SEM view 1400 of enlarged positive mask nano-structures 1412, 1414 following a positive mask deposition step, according to an embodiment of the present invention. FIG. 14B illustrates a wider view of perspective SEM image 1400 of the enlarged positive mask nano-structures 1412, 1414 illustrated in FIG. 14A following a positive mask deposition step, In the views of SEM image 1400 shown in FIGs. 14A and 14B, the exemplary enlarged positive mask nano-structures 1412, 1414 comprise a positive mask material layer 1410 which is deposited on top of the substrate its profile layers such as by a positive mask deposition step 800, as shown in FIGs. 8A and 8B and described in detail above, for example. The exemplary enlarged positive mask nano-structures 1412, 1414 shown in SEM image 1400 are shown deposited on the surface of an underlying substrate layer and within corresponding enlarged nano-structures in a pattern transfer layer and corresponding enlarged lift-off structures in a lift-off layer situated between the substrate and pattern transfer layer, for example. As can be seen in the SEM image 1400, the enlarged positive mask nano-structures 1412, 1414 which are deposited on the substrate surface through the enlarged nano-structures in the pattern transfer layer are desirably separated from the positive mask material 1410 deposited on top of the pattern transfer layer during the positive mask deposition step, such as for desirably facilitating effective removal of the lift-off and pattern transfer layers in a subsequent lift-off removal step (such as lift-off removal step 900 as described above with reference to FIGs. 9A and 9B for example) to reveal the enlarged positive mask nano-structures 1412, 1414 deposited on the substrate surface.

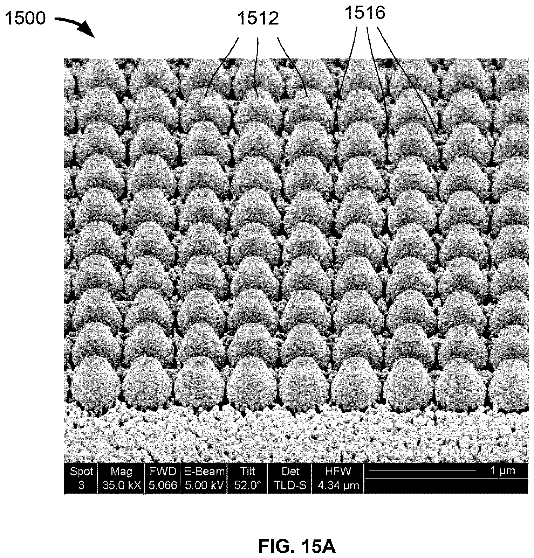

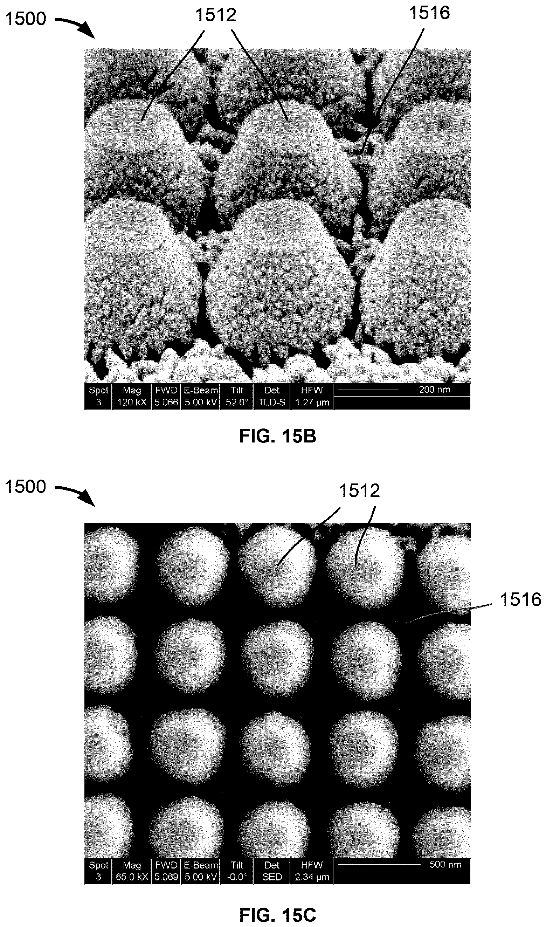

Referring now to FIGs. 15A, 15B and 15C, FIG. 15A illustrates a perspective SEM view 1500 of exemplary completed enlarged out of plane nano-structures 1512 manufactured according to an embodiment of the present invention. FIG. 15B illustrates a closeup of the perspective SEM image 1500 of the exemplary completed enlarged out of plane nano-structures 1512 illustrated in FIG. 15A, according to an embodiment of the present invention. FIG. 15C illustrates a closeup top view of the SEM image 1500 of the exemplary completed enlarged out of plane nano-structures 1512 illustrated in FIG. 15A, according to an embodiment of the present invention. In the views of SEM image 1500 shown in FIGs. 15A, 15B and 15C, exemplary completed enlarged out of plane nano-structures 1512 are shown extending out of plane from an etched surface 1516 of the substrate layer between nano-structures 1512, such as produced by a directional anisotropic etch step 1000 as described above with reference to FIGs. 10A and 10B, for example. In the case of the exemplary completed enlarged out of plane nano-structures 1512 according to one embodiment of the present invention, the desired completed form of the nano-structures 1512 is that of out of plane pillars or columns, such as may be manufactured using exemplary steps 300-1000 as described above and shown in FIGs. 3A to 10B, for example.

## Claims

1. A method of fabricating nano-structures on a substrate surface by reducing the use of a writing tool, comprising:
a) providing a suitable substrate material comprising a substrate, and process layers sequentially deposited on said substrate comprising: a lift-off layer in contact with said substrate, a pattern transfer layer on top of said lift-off layer, and a writing layer on top of said pattern transfer layer, wherein said writing layer comprises a photoresist or an electron-beam resist material;
b) patterning pilot nano-structures in said writing layer by exposure of said writing layer to an electron-beam lithography tool to reveal said pattern transfer layer underneath at locations of said pilot nano-structures, wherein said pilot-nanostructures formed in said writing layer represent a desired location and/or geometry of final nano-structures to be produced on a surface of said substrate, and wherein said pilot-nano-structures comprise only a portion of a size of said final nano-structures;
c) transferring and enlarging said pilot nano-structures into said pattern transfer layer by applying a substantially isotropic etch selective for said pattern transfer layer to undercut said pattern transfer layer and create enlarged nano-structures in said pattern transfer layer at locations underneath said locations of said pilot nano-structures, wherein a diameter of said enlarged nano-structures in said pattern transfer layer is larger than a diameter of said pilot nano-structures in said writing layer, the enlarged nano-structures comprising at least one of nano-holes, nano-slots and nano-grooves;
d) undercutting said lift-off layer using a lift-off etch selective for said lift-off layer to create enlarged lift-off structures in said lift-off layer beneath the locations of said enlarged nano-structures in said pattern transfer layer to reveal said substrate underneath said locations of said enlarged nano-structures in said pattern transfer layer;
e) removing said writing layer to reveal said enlarged nano-structures in said pattern transfer layer; and
f) after removing said writing layer, applying a directional anisotropic etch to said substrate through said enlarged nano-structures in said pattern transfer layer to produce enlarged nano-structures in said surface of said substrate at locations underneath said locations of said enlarged nanostructures in said pattern transfer layer, wherein said enlarged nano-structures in said surface of said substrate comprise said final nano-structures.

2. The method of fabricating nano-structures on a substrate surface according to claim 1, wherein said step e) additionally comprises:
depositing a positive mask material through said enlarged nano-structures in said pattern transfer layer to create enlarged positive mask nano-structures on said substrate at locations underneath said locations of said enlarged nano-structures in said pattern transfer layer; and removing said lift-off layer and said pattern transfer layer to reveal said enlarged positive mask nano-structures on said substrate.

3. The method of fabricating nano-structures on a substrate surface according to claim 1, further comprising:
g) removing said lift-off layer and said pattern transfer layer to reveal said final enlarged nano-structures etched into said substrate.

4. The method of fabricating nano-structures on a substrate surface according to claim 1, 2, or 3, wherein the diameter of said enlarged nano-structures in said pattern transfer layer is approximately 400nm and the diameter of said pilot nano-structures in said writing layer is approximately 100nm.

5. The method of fabricating nano-structures on a substrate surface according to any one of claims 1 to 4, wherein at least one of a diameter and a width dimension of said enlarged nano-structures in said pattern transfer layer is at least twice as large as at least one of a diameter and a width dimension of said pilot nano-structures in said writing layer.

6. The method of fabricating nano-structures on a substrate surface according to any one of claims 1 to 5, wherein said substrate comprises at least one material selected from the list comprising: silicon, silicon based materials, quartz, fused quartz, SiO₂ based materials, glass, polymers, resins, sapphire, Al₂O₃ based materials, nickel, and nickel containing alloys.

7. The method of fabricating nano-structures on a substrate surface according to any one of claims 1 to 6, wherein said lift-off layer, said pattern transfer layer and said writing layer are deposited by at least one of: coating, spin-coating, physical vapor deposition, chemical vapor deposition, plasma-enhanced chemical vapor deposition, molecular beam epitaxy, atomic layer deposition, and laser ablation.

8. The method of fabricating nano-structures on a substrate surface according to any one of claims 1 to 7, wherein said substantially isotropic etch comprises application of at least one of: a substantially isotropic wet chemical etchant, a substantially isotropic gaseous etch ant, and a substantially isotropic plasma etchant.

9. The method of fabricating nano-structures on a substrate surface according to any one of claims 1 to 8, wherein at least one of an extent and a rate of enlargement of said enlarged nano-structures in said pattern transfer layer using said substantially isotropic etch is controllable to determine a selected enlargement of said enlarged nano-structures relative to said pilot nano-structures.

10. The method of fabricating nano-structures on a substrate surface according to any one of claims 1 to 9, wherein said directional anisotropic etch is directed substantially normal to the surface of said substrate and comprises at least one of a chemical, gaseous, plasma, and reactive ion etch.

11. The method of fabricating nano-structures on a substrate surface according to any one of claims 1 to 10, wherein said lift-off etch comprises at least one of: a wet chemical etchant, a gaseous etchant, a plasma etchant, and a reactive ion etchant.

## Patentansprüche

1. Verfahren zur Herstellung von Nanostrukturen auf einer Substratoberfläche durch Verringern der Verwendung eines Schreibwerkzeugs, umfassend:
a) Bereitstellen eines geeigneten Substratmaterials, das ein Substrat umfasst, und Verarbeiten von Schichten, die aufeinanderfolgend auf das Substrat aufgebracht werden, umfassend: eine Abhebeschicht in Kontakt mit dem Substrat, eine Strukturübertragungsschicht auf der Abhebeschicht und eine Schreibschicht auf der Strukturübertragungsschicht, wobei die Schreibschicht ein Photoresist- oder Elektronenstrahlresistmaterial umfasst;
b) Strukturieren von Pilot-Nanostrukturen in der Schreibschicht durch Exposition der Schreibschicht gegenüber einem Elektronenstrahllithographiewerkzeug, um die Strukturübertragungsschicht unterhalb von Stellen der Pilot-Nanostrukturen freizulegen, wobei die in der Schreibschicht gebildeten Pilot-Nanostrukturen eine gewünschte Stelle und/oder Geometrie von fertigen Nanostrukturen darstellen, die auf der Oberfläche des Substrats gebildet werden sollen, und wobei die Pilot-Nanostrukturen nur einen Teil einer Größe der fertigen Nanostrukturen umfassen;
c) Übertragen und Vergrößern der Pilot-Nanostrukturen in die Strukturübertragungsschicht durch Anwenden einer im Wesentlichen isotropen Ätzung, die für die Strukturübertragungsschicht selektiv ist, um die Strukturübertragungsschicht zu hinterschneiden und vergrößerte Nanostrukturen in der Strukturübertragungsschicht an Stellen unterhalb der Stellen der Pilot-Nanostrukturen zu erzeugen, wobei ein Durchmesser der vergrößerten Nanostrukturen in der Strukturübertragungsschicht größer als ein Durchmesser der Pilot-Nanostrukturen in der Schreibschicht ist, wobei die vergrößerten Nanostrukturen wenigstens eines von Nanolöchern, Nanoschlitzen und Nanorillen umfassen;
d) Hinterschneiden der Abhebeschicht unter Verwendung einer Abhebeätzung, die für die Abhebeschicht selektiv ist, um vergrößerte Abhebestrukturen in der Abhebeschicht unterhalb der Stellen der vergrößerten Nanostrukturen in der Strukturübertragungsschicht zu erzeugen, um das Substrat unterhalb der Stellen der vergrößerten Nanostrukturen in der Strukturübertragungsschicht freizulegen;
e) Entfernen der Schreibschicht, um die vergrößerten Nanostrukturen in der Strukturübertragungsschicht freizulegen; und
f) nach dem Entfernen der Schreibschicht Anwenden einer richtungsabhängigen anisotropen Ätzung an das Substrat durch die vergrößerten Nanostrukturen in der Strukturübertragungsschicht, um vergrößerte Nanostrukturen in der Oberfläche des Substrats an Stellen unterhalb der Stellen der vergrößerten Nanostrukturen in der Strukturübertragungsschicht zu erzeugen, wobei die vergrößerten Nanostrukturen in der Oberfläche des Substrats die fertigen Nanostrukturen umfassen.

2. Verfahren zur Herstellung von Nanostrukturen auf einer Substratoberfläche gemäß Anspruch 1, wobei Schritt e) zusätzlich umfasst:
Aufbringen eines Positivmaskenmaterials durch die vergrößerten Nanostrukturen in der Strukturübertragungsschicht, um vergrößerte Positivmasken-Nanostrukturen auf dem Substrat an Stellen unterhalb der Stellen der vergrößerten Nanostrukturen in der Strukturübertragungsschicht zu erzeugen; und Entfernen der Abhebeschicht und der Strukturübertragungsschicht, um die vergrößerten Positivmasken-Nanostrukturen auf dem Substrat freizulegen.

3. Verfahren zur Herstellung von Nanostrukturen auf einer Substratoberfläche gemäß Anspruch 1, ferner umfassend:
g) Entfernen der Abhebeschicht und der Strukturübertragungsschicht, um die fertigen vergrößerten Nanostrukturen, die in das Substrat geätzt sind, freizulegen.

4. Verfahren zur Herstellung von Nanostrukturen auf einer Substratoberfläche gemäß Anspruch 1, 2 oder 3, wobei der Durchmesser der vergrößerten Nanostrukturen in der Strukturübertragungsschicht etwa 400 nm beträgt und der Durchmesser der Pilot-Nanostrukturen in der Schreibschicht etwa 100 nm beträgt.

5. Verfahren zur Herstellung von Nanostrukturen auf einer Substratoberfläche gemäß einem der Ansprüche 1 bis 4, wobei wenigstens eines von einem Durchmesser und einer Breitenabmessung der vergrößerten Nanostrukturen in der Strukturübertragungsschicht wenigstens zweimal so groß wie wenigstens eines von einem Durchmesser und einer Breitenabmessung der Pilot-Nanostrukturen in der Schreibschicht ist.

6. Verfahren zur Herstellung von Nanostrukturen auf einer Substratoberfläche gemäß einem der Ansprüche 1 bis 5, wobei das Substrat wenigstens ein Material ausgewählt aus der Liste umfassend: Silicium, Materialien auf Siliciumbasis, Quarz, Quarzglas, Materialien auf SiO₂-Basis, Glas, Polymere, Harze, Saphir, Materialien auf Al₂O₃-Basis, Nickel und nickelhaltige Legierungen, umfasst.

7. Verfahren zur Herstellung von Nanostrukturen auf einer Substratoberfläche gemäß einem der Ansprüche 1 bis 6, wobei die Abhebeschicht, die Strukturübertragungsschicht und die Schreibschicht durch wenigstens eines von: Beschichten, Aufschleudern, physikalische Gasphasenabscheidung, chemische Gasphasenabscheidung, plasmaverstärkte chemische Gasphasenabscheidung, Molekülstrahlepitaxie, Atomschichtabscheidung und Laserablation aufgebracht werden.

8. Verfahren zur Herstellung von Nanostrukturen auf einer Substratoberfläche gemäß einem der Ansprüche 1 bis 7, wobei die im Wesentlichen isotrope Ätzung Anwenden von wenigstens einem von: einem im Wesentlichen isotropen nasschemischen Ätzmittel, einem im Wesentlichen isotropen gasförmigen Ätzmittel und einem im Wesentlichen isotropen Plasmaätzmittel umfasst.

9. Verfahren zur Herstellung von Nanostrukturen auf einer Substratoberfläche gemäß einem der Ansprüche 1 bis 8, wobei wenigstens eines von einer Abmessung und einer Vergrößerungsrate der vergrößerten Nanostrukturen in der Strukturübertragungsschicht unter Verwendung der im Wesentlichen isotropen Ätzung steuerbar ist, um eine ausgewählte Vergrößerung der vergrößerten Nanostrukturen im Vergleich zu den Pilot-Nanostrukturen zu bestimmen.

10. Verfahren zur Herstellung von Nanostrukturen auf einer Substratoberfläche gemäß einem der Ansprüche 1 bis 9, wobei die richtungsabhängige anisotrope Ätzung im Wesentlichen senkrecht auf die Oberfläche des Substrats gerichtet ist und wenigstens eines von einer chemischen, Gas-, Plasma- und reaktiven Ionenätzung umfasst.

11. Verfahren zur Herstellung von Nanostrukturen auf einer Substratoberfläche gemäß einem der Ansprüche 1 bis 10, wobei die Abhebeätzung wenigstens eines von: einem nasschemischen Ätzmittel, einem gasförmigen Ätzmittel, einem Plasmaätzmittel und einem reaktiven Ionenätzmittel umfasst.

## Revendications

1. Procédé de fabrication de nanostructures sur une surface de substrat avec réduction de l'utilisation d'un outil d'écriture, comprenant :
a) l'obtention d'un matériau substrat approprié comprenant un substrat, et des couches de traitement déposées successivement sur ledit substrat comprenant : une couche de décollement en contact avec ledit substrat, une couche de transfert de motif au-dessus de ladite couche de décollement, et une couche d'écriture au-dessus de ladite couche de transfert de motif, ladite couche d'écriture comprenant une résine photosensible ou un matériau de réserve pour faisceau d'électrons ;
b) le modelage de nanostructures pilotes dans ladite couche d'écriture par exposition de ladite couche d'écriture à un outil de lithographie par faisceau d'électrons pour révéler ladite couche de transfert de motif sous-jacente à des emplacements desdites nanostructures pilotes, lesdites nanostructures pilotes formées dans ladite couche d'écriture représentant un emplacement et/ou une géométrie souhaités de nanostructures finales devant être produites sur une surface dudit substrat, et lesdites nanostructures pilotes comprenant uniquement une partie d'une taille desdites nanostructures finales ;
c) le transfert et l'élargissement desdites nanostructures pilotes à l'intérieur de ladite couche de transfert de motif par application d'une gravure sensiblement isotrope sélective pour ladite couche de transfert de motif pour graver de façon sous-jacente ladite couche de transfert de motif et créer des nanostructures élargies dans ladite couche de transfert de motif à des emplacements au-dessous desdits emplacements desdites nanostructures pilotes, un diamètre desdites nanostructures élargies dans ladite couche de transfert de motif étant plus grand qu'un diamètre desdites nanostructures pilotes dans ladite couche d'écriture, les nanostructures élargies comprenant des nanotrous, et/ou des nanofentes, et/ou des nanorainures ;
d) la gravure sous-jacente de ladite couche de décollement au moyen d'une gravure de décollement sélective pour ladite couche de décollement pour créer des structures de décollement élargies dans ladite couche de décollement au-dessous des emplacements desdites nanostructures élargies dans ladite couche de transfert de motif pour révéler ledit substrat au-dessous desdits emplacements desdites nanostructures élargies dans ladite couche de transfert de motif ;
e) le retrait de ladite couche d'écriture pour révéler lesdites nanostructures élargies dans ladite couche de transfert de motif ; et
f) après le retrait de ladite couche d'écriture, l'application d'une gravure anisotrope directionnelle audit substrat à travers lesdites nanostructures élargies dans ladite couche de transfert de motif pour produire des nanostructures élargies dans ladite surface dudit substrat à des emplacements au-dessous desdits emplacements desdites nanostructures élargies dans ladite couche de transfert de motif, lesdites nanostructures élargies dans ladite surface dudit substrat comprenant lesdites nanostructures finales.

2. Procédé de fabrication de nanostructures sur une surface de substrat selon la revendication 1, dans lequel ladite étape e) comprend également :
le dépôt d'un matériau de masque positif à travers lesdites nanostructures élargies dans ladite couche de transfert de motif pour créer des nanostructures de masque positif élargies sur ledit substrat à des emplacements au-dessous desdits emplacements desdites nanostructures élargies dans ladite couche transfert de motif ; et le retrait de ladite couche de décollement et de ladite couche de transfert de motif pour révéler lesdites nanostructures de masque positif élargies sur ledit substrat.

3. Procédé de fabrication de nanostructures sur une surface de substrat selon la revendication 1, comprenant en outre :
g) le retrait de ladite couche de décollement et de ladite couche de transfert de motif pour révéler lesdites nanostructures élargies finales gravées à l'intérieur dudit substrat.

4. Procédé de fabrication de nanostructures sur une surface de substrat selon la revendication 1, 2 ou 3, dans lequel le diamètre desdites nanostructures élargies dans ladite couche de transfert de motif est d'environ 400 nm et le diamètre desdites nanostructures pilotes dans ladite couche d'écriture est d'environ 100 nm.

5. Procédé de fabrication de nanostructures sur une surface de substrat selon l'une quelconque des revendications 1 à 4, dans lequel une dimension en diamètre et/ou en largeur desdites nanostructures élargies dans ladite couche de transfert de motif est au moins deux fois plus grande qu'une dimension en diamètre et/ou en largeur desdites nanostructures pilotes dans ladite couche d'écriture.

6. Procédé de fabrication de nanostructures sur une surface de substrat selon l'une quelconque des revendications 1 à 5, dans lequel ledit substrat comprend au moins un matériau choisi dans la liste comprenant : le silicium, les matériaux à base de silicium, le quartz, le verre de quartz, les matériaux à base de SiO₂, le verre, les polymères, les résines, le saphir, les matériaux à base d'Al₂O₃, le nickel, et les alliages contenant du nickel.

7. Procédé de fabrication de nanostructures sur une surface de substrat selon l'une quelconque des revendications 1 à 6, dans lequel ladite couche de décollement, ladite couche de transfert de motif et ladite couche d'écriture sont déposées par au moins une technique parmi : l'enduction, l'enduction à la tournette, le dépôt physique en phase vapeur, le dépôt chimique en phase vapeur, le dépôt chimique en phase vapeur assisté par plasma, l'épitaxie par jet moléculaire, le dépôt de couches atomiques, et l'ablation laser.

8. Procédé de fabrication de nanostructures sur une surface de substrat selon l'une quelconque des revendications 1 à 7, dans lequel ladite gravure sensiblement isotrope comprend l'application d'au moins un élément parmi : un agent chimique de gravure humide sensiblement isotrope, un agent gazeux de gravure sensiblement isotrope, et un agent de gravure par plasma sensiblement isotrope.

9. Procédé de fabrication de nanostructures sur une surface de substrat selon l'une quelconque des revendications 1 à 8, dans lequel une étendue et/ou un taux d'élargissement desdites nanostructures élargies dans ladite couche de transfert de motif au moyen de ladite gravure sensiblement isotrope sont contrôlables pour déterminer un élargissement sélectionné desdites nanostructures élargies par rapport auxdites nanostructures pilotes.

10. Procédé de fabrication de nanostructures sur une surface de substrat selon l'une quelconque des revendications 1 à 9, dans lequel ladite gravure anisotrope directionnelle est dirigée de façon sensiblement perpendiculaire à la surface dudit substrat et en comprend au moins une parmi la gravure chimique, gazeuse, par plasma, et ionique réactive.

11. Procédé de fabrication de nanostructures sur une surface de substrat selon l'une quelconque des revendications 1 à 10, dans lequel ladite couche de décollement comprend au moins un élément parmi : un agent chimique de gravure humide, un agent gazeux de gravure, un agent de gravure par plasma, et un agent de gravure ionique réactive.
